# EUROPÄISCHE PATENTSCHRIFT

(11) **EP 2 081 796 B1**
(45) Veröffentlichungstag und Bekanntmachung des Hinweises auf die Patenterteilung: **02.07.2014**
(21) Anmeldenummer: 07821405.3
(22) Anmeldetag: 16.10.2007
(51) Int. Cl.: H05K 5/00, H05K 7/14, E05F 15/16, E05F 15/20, H02K 11/00, H02K 5/22, H02K 7/116

(54) **STEUEREINHEIT ZUM STEUERN EINER ELEKTROMOTORISCHEN ANTRIEBSEINHEIT**
CONTROL UNIT FOR CONTROLLING AN ELECTROMOTIVE DRIVE UNIT
UNITÉ DE COMMANDE POUR COMMANDER UNE UNITÉ D'ENTRAÎNEMENT À MOTEUR ÉLECTRIQUE

(30) Priorität: 20.10.2006 DE 102006049635
(43) Veröffentlichungstag der Anmeldung: 29.07.2009
(73) Patentinhaber: Continental Automotive GmbH, 30165 Hannover (DE)
(72) Erfinder: MALY, Heinrich, 2542 Kottingbrunn (AT)
(86) Internationale Anmeldenummer: PCT/EP2007/061040
(87) Internationale Veröffentlichungsnummer: WO 2008/046832

(56) Entgegenhaltungen:
- DE-A1- 10 108 414
- DE-A1- 10 127 652
- DE-A1- 19 851 455
- DE-C1- 19 839 333
- DE-U1-202004 015 409

## Beschreibung

### Technisches Gebiet

Die Erfindung betrifft eine Steuereinheit zum Steuern einer elektromotorischen Antriebseinheit, mit einem Gehäuse, das mittels einer mechanischen Schnittstellen-Vorrichtung mit der Antriebseinheit verbindbar ist, und mit einer am Gehäuse ausgebildeten Steckvorrichtung, zum Anschließen eines von außen an das Gehäuse heran geführten Kabels, wobei die Steckvorrichtung zumindest einen Steckerschacht aufweist, in welchem Kontaktstifte angeordnet sind, die mit Leiterbahnen einer im Gehäuse angeordneten Schaltungsplatine elektrisch verbunden sind.

### Stand der Technik

Aus der DE 101 41 246 C1 ist eine Antriebseinheit für einen elektrischen Fensterheber in einer Fahrzeugtür beschrieben, der mittels einer mechanischen Schnittstellen-Vorrichtung mit einer Steuereinheit mechanisch und elektrisch verbindbar ist. Die Steuereinheit weist ein aus zwei Halbschalen gebildetes, quaderförmiges Gehäuse auf. An einer zur Außenseite der Tür bzw. in den Fahrgastraum weisenden Seite des Gehäuses ist eine Steckvorrichtung vorgesehen, die zum Anschluss eines Kabels dient, durch welches die Steuereinheit mit einer Kraftfahrzeugbatterie bzw. mit Steuerleitungen eines KfZ-Bus verbunden ist. Die mehrteilige Ausführung des Gehäuses, bei dem die Steckvorrichtung oftmals ein separates, in einer Einbuchtung eingelegtes Steckerbauteil bildet, ist in der Herstellung aufwändig. Die seitliche Anordnung der Steckvorrichtung ist von Nachteil, da in der Fahrzeugtür der zur Verfügung stehende Einbauraum eng begrenzt ist. Das mehrteilige Gehäuse ist nicht dicht; es lässt sich nur in der Trockenseite der Tür einsetzen.

Weiterhin ist aus der DE 198 39 333 C1 eine Antriebseinrichtung für ein in einem Kraftfahrzeug vorhandenes verstellbares Aggregat bekannt, die eine Steuereinheit aufweist, wobei zur Realisierung eines einfachen Aufbaus die Steuereinheit seitlich an den einem Schnittstellenbereich zugeordneten Gehäuseabschnitt einer Motor/Getriebe-Kombination angrenzt. Das Gehäuse besteht aus einem Unterteil und einem separaten Oberteil. An der dem Schnittstellenbereich zugewandten Seite des Unterteils ist ein Steckverbindungsteil zur Verbindung mit der Motor/Getriebe-Kombination vorgesehen. An dem Oberteil ist ein Steckverbindungsteil vorgesehen mit dem die Steuereinheit mit einer elektrischen Zuleitung verbindbar ist.

### Darstellung der Erfindung

Es ist eine Aufgabe der vorliegenden Erfindung eine Steuereinheit anzugeben, die einfacher herzustellen ist und die in Richtung der Türbreite eine geringere Einbautiefe aufweist.

Diese Aufgabe wird durch eine Steuereinheit mit den Merkmalen des Patentanspruchs 1 gelöst. Auf vorteilhafte Ausgestaltungen nehmen die abhängigen Ansprüche Bezug. Die erfindungsgemäße Steuereinheit zum Steuern einer elektromotorischen Antriebseinheit, weist ein Gehäuse auf, das mittels einer mechanischen Schnittstellen-Vorrichtung mit der Antriebseinheit verbindbar ist. Am Gehäuse ist eine Steckvorrichtung ausgebildet, zum Anstecken eines von außen an das Gehäuse heran geführten Kabels, wobei Kontaktstifte der Steckvorrichtung in zumindest einem Steckerschacht der Steckvorrichtung angeordnet sind und mit Leiterbahnen einer Schaltungsplatine, die im Inneren des Gehäuses angeordnet ist, elektrisch verbunden sind. Die Steuereinheit ist dadurch gekennzeichnet, dass das Gehäuse in Form eines quaderförmigen Bechers ausgebildet ist und ein Bodenteil an einer von der Antriebseinheit abgewandten Seite, sowie eine Öffnung auf der dem Bodenteil gegenüberliegenden und der Antriebseinheit zugewandten Seite aufweist. Weiterhin ist auf der der Antriebseinheit zugewandten Seite des Gehäuses zur mechanischen Schnittstellen-Vorrichtung hin eine Dichtvorrichtung zum wasserdichten abschließen der oben genannten Öffnung des Gehäuses mit der mechanischen Schnittstellen-Vorrichtung vorgesehen, und der zumindest eine Steckerschacht ist an der von der Antriebsvorrichtung abgewandten Seite des Gehäuses am Bodenteil angeordnet und durch einen gehäuseaußenseitig angeformten Steckerkragen gebildet, der mit dem Bodenteil und dem Gehäuse einstückig und materialeinheitlich aus einem polymeren Werkstoff gebildet ist.

Durch die erfindungsgemäße Anordnung der Steckvorrichtung baut die Steuereinheit seitlich weniger auf. Der Einsatz der Steuereinheit ist auch in Fahrzeugtüren möglich, die eine geringe Türbreite aufweisen. Die Herstellung des Gehäuses kann durch Spritzgießen aus Kunststoff erfolgen, wobei nur ein einziges Spritzgusswerkzeug erforderlich ist.

In einer bevorzugten Ausführungsform kann vorgesehen sein, dass im Inneren des Gehäuses eine Führungsvorrichtung ausgebildet ist, in welche die Schaltungsplatine von einer Öffnung des becherförmigen Gehäuses in Richtung des Bodenteils einschiebbar ist. Das Bodenteil weist im Bereich der oder des Steckerschachts Durchstecköffnungen auf. Diese Durchstecköffnungen sind so bemessen, dass Steckkontakte, welche mit einem Ende an der Schaltungsplatine befestigt sind, mit einem parallel zur Ebene der Schaltungsplatine in Einschubrichtung gebogenen Ende, durchsteckbar sind. Dadurch entfallen aufwändige Montagewerkzeuge, die bislang für eine Steckvorrichtung, die als gesondertes Teil ausgebildet ist, erforderlich waren.

Mit Vorteil sind die Durchstecköffnungen in Einschubrichtung gesehen konisch zulaufend ausgebildet. Dadurch ist das Einfädeln der Steckkontakte einfacher.

Bevorzugt wird hierbei ein lichter Durchmesser der Durchstecköffnung, der größer ist als ein Kontaktdurchmesser bzw. eine Querschnittsdiagonale eines Kontaktpfostens.

Zweckmäßig ist es, wenn die Steckkontakte als 90 Grad abgewinkelte Kontaktstifte ausgebildet sind.

Die Steckerstifte bzw. Steckerpfosten werden bevorzugt aus Bronze hergestellt, wobei die Anformung einer elastischen Einpresszone, zum Einpressen in eine Bohrung der Schaltungsplatine, günstig ist.

Die Befestigung der Steckerstifte bzw. Steckerpfosten auf der Schaltungsplatine kann bevorzugt entweder durch eine materialschlüssige Lötverbindung oder durch eine reibschlüssige Verbindung, z.B. durch eine Einpreßverbindung erfolgen. Beide Verbindungstechniken sind dem Fachmann geläufig.

Bevorzugt wird eine Ausführung der Führungselemente, welche aus Leisten oder nutförmigen Vertiefungen besteht, die an gegenüberliegenden Schmalseiten im Inneren des Gehäuses parallel verlaufend, in Richtung des Bodenteils ausgebildet sind.

Mit Vorteil lässt sich die erfindungsgemäße Ausbildung des Gehäuses durch eine motorseitig und eine steckerseitig angeordnete Dichtungsvorrichtung wasserdicht ausführen. Damit werden Schmutzpartikel und Feuchtigkeit von der Schaltung auf der Schaltungsplatine fern gehalten; es ist auch ein Einsatz im Nassbereich der KfZ-Tür möglich.

### Kurzbeschreibung der Zeichnungen

Zur weiteren Erläuterung der Erfindung wird im nachfolgenden Teil der Beschreibung auf die Zeichnungen Bezug genommen in denen weitere vorteilhafte Ausgestaltungen, Einzelheiten und Weiterbildungen der Erfindung zu entnehmen sind.
Es zeigt:
- Figur 1: ein Ausführungsbeispiel der erfindungsgemäßen Steuereinheit, wie sie für einen elektrischen Fensterheberantrieb eines Kraftfahrzeugs eingesetzt wird, vor dem Verbinden mit einer elektromotorischen Antriebseinheit;
- Figur 2: eine Draufsicht auf die erfindungsgemäße Steuereinheit der Figur 1;
- Figur 3: eine geschnittene Darstellung der erfindungsgemäßen Steuereinheit entlang der Linie X-X der Figur 2;
- Figur 4: eine Seitenansicht mit Blick auf das Bodenteil des Gehäuses;
- Figur 5: eine auseinander gezogene Darstellung der erfindungsgemäßen Steuereinheit
- Figur 6: eine Detailzeichnung im Bereich "Detail X" der Figur 3.

### Ausführung der Erfindung

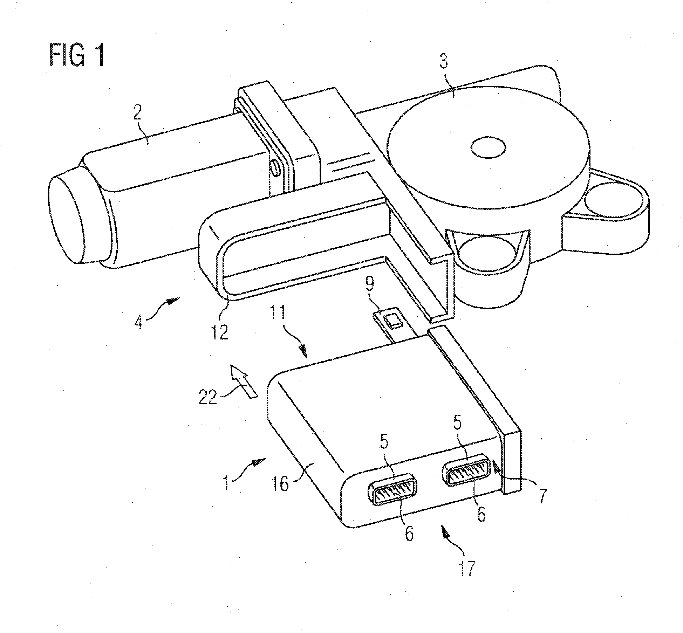

Die Figur 1 zeigt in einer räumlichen Darstellung eine Antriebseinheit für einen elektrischen Fensterheber, bestehend im wesentlichen aus einem Motor 2 und einem Getriebe 3 , einer Steuereinheit 1 und einer Schnittstellen-Vorrichtung 4, durch welche die Steuereinheit 1 mit dem Motor-Getriebegehäuse elektrisch und mechanisch verbindbar ist. Zum Herstellen der Verbindung wird in Figur 1 Steuereinheit 1 in Richtung des Pfeils 22 in der gezeichneten Führung eingeschoben.

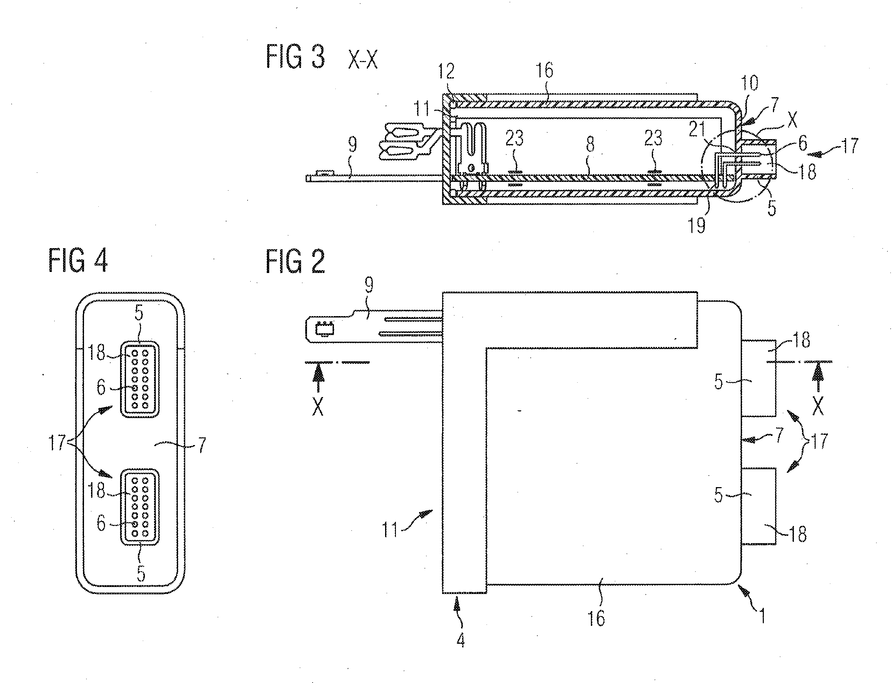

In Figur 2 ist die Steuereinheit 1 in einer Draufsicht zu sehen. Die Steuereinheit 1 weist ein Gehäuse 16 auf, das die Form eines quaderförmigen Bechers hat. Das Gehäuse 16 ist durch Spritzgießen aus einem polymeren Werkstoff hergestellt. Das Gehäuse 16 ist zu der einen Seite 11 hin offen. Gegenüberliegend zu dieser Öffnung 11 ist an einem Bodenteil 6 10 eine elektrische Steckvorrichtung 17 ausgebildet. Diese Steckvorrichtung 17 besteht im vorliegenden Ausführungsbeispiel aus einem ersten und einem zweiten Steckerschacht 18; jeder dieser Steckerschächte 18 wird jeweils durch einen außenseitig am Bodenteil 10 angeformten Steckerkragen 5 gebildet. Jeder Steckerkragen 5 ist an das Gehäuse 16 durch Spritzgießen angeformt.

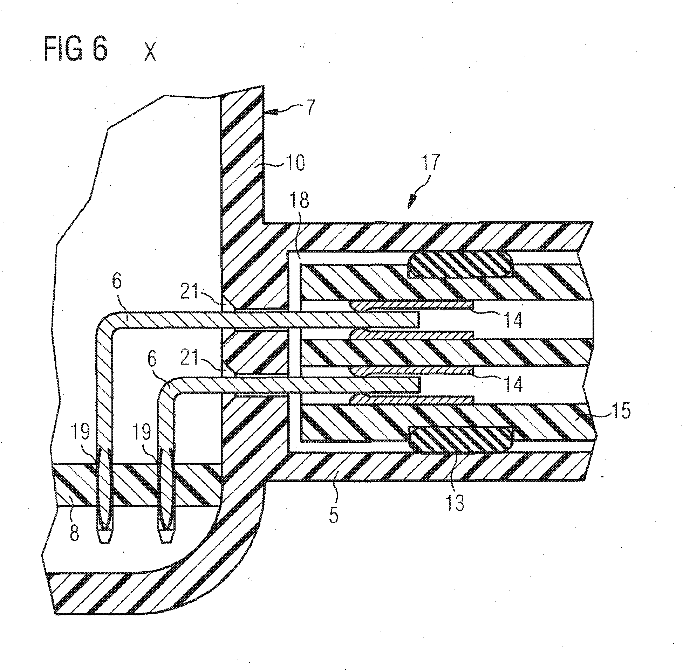

Die Schnittzeichnung in Figur 3 zeigt eine im Inneren des Gehäuses 16 angeordnete Schaltungsplatine 8. Diese Schaltungsplatine 8 ist in Führungsleisten 23 einer Führungseinrichtung eingeschoben. An der in Einschubstellung zur Steckvorrichtung 18 liegenden Seite der Schaltungsplatine 8 sind Bohrungen 19 ausgebildet. In den Bohrungen 19 sind abgewinkelte Steckkontakte 6 befestigt. Die Steckkontakte 6 sind als Kontaktstifte ausgebildet. Die Befestigung auf der Schaltungsplatine 8 erfolgt durch Einpressen, kann aber durch Löten erfolgen. Die Steckkontakte 6 sind mit dem in Einschubrichtung zeigenden Ende durch Durchstecköffnungen 21 (Detail X in Figur 6) im Bodenteil 10 des Gehäuses 16 durchgesteckt. An dem zum Motor 2 liegenden Ende der Schaltungsplatine 8 ist eine Leiterplattenzunge 9 ausgebildet, die einen Hallsensor trägt, der zur Erfassung der Drehlage des Rotors des Motors 2 dient.

Die Figur 4 zeigt die Steuereinheit in einer Seitenansicht mit Blick auf die Steckvorrichtung 17.

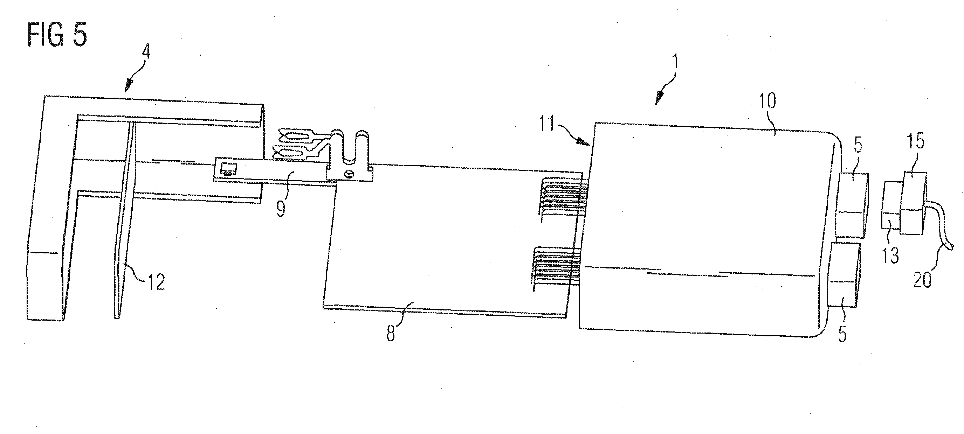

Die Figur 5 zeigt die Steuereinheit 1 in einer auseinander gezogenen Darstellung. In der Figur 5 ist mit dem Bezugszeichen 12 eine Dichtvorrichtung bezeichnet, durch welche das Gehäuse mit der mechanischen Schnittstellen-Vorrichtung 4 wasserdicht abgeschlossen ist. Steckerseitig erfolgt die Abdichtung mittels einer Dichtvorrichtung 13, die an dem, am Kabel 20 angeschlagenen Steckerbuchsenteil 15 vorgesehen ist.

Die Figur 6 zeigt ein "Detail X" gemäß Figur 2 in einer Schnittdarstellung. Die Kontaktstifte 6 sind in Figur 6 um etwa 90 Grad gebogen. Vertikalen Endstücke der Kontaktstifte 6 sind in Bohrungen 19 der Schaltungsplatine 8 eingesteckt; im gezeigten Beispiel ist die Verbindung in Einpresstechnik ausgeführt. Die horizontal gerichteten Endstücke der Kontaktstifte 6 sind durch Durchstecköffnungen 21 durchgesteckt. Die Durchstecköffnungen 21 sind vom Inneren des Gehäuses her gesehen zumindest in einem Einsteckbereich konisch. Dies erleichtert das Einfädeln der Kontaktstifte 6 beim Einschieben der Schaltungsplatine 8. Die Kontaktstifte 6 ragen mit dem parallel zur Schaltungsplatine 8 verlaufenden Ende in den Steckerschacht 18. In der abgerissenen Darstellung der Figur 6 ist im Steckerschacht 18 eine eingesteckte Steckerbuchse 15 gezeichnet. Die Kontaktierung der einzelnen Kontaktstifte 6 mit Leitern des Kabels 20 erfolgt mittels Kontaktfedern 14, die in der Steckerbuchse 15 ausgebildet sind. Die steckerseitige Abdichtung erfolgt mittels einer umlaufenden Silikondichtung 13, die in einer Nut der Steckbuchse 15 gehalten ist.

## Patentansprüche

1. Steuereinheit zum Steuern einer elektromotorischen Antriebseinheit,
- mit einem Gehäuse (16), das mittels einer mechanischen Schnittstellen-Vorrichtung (4) mit der Antriebseinheit verbindbar ist, und
- mit einer am Gehäuse ausgebildeten Steckvorrichtung (17), zum Anstecken eines von außen an das Gehäuse heran geführten Kabels (20), wobei Kontaktstifte(6) der Steckvorrichtung in zumindest einem Steckerschacht (18) der Steckvorrichtung (17) angeordnet sind und mit Leiterbahnen einer Schaltungsplatine (8), die im Inneren des Gehäuses angeordnet ist, elektrisch verbunden sind, **dadurch gekennzeichnet,**
- **dass** das Gehäuse (16) in Form eines quaderförmigen Bechers ausgebildet ist und ein Bodenteil (10) an einer von der Antriebseinheit abgewandten Seite (7), sowie eine Öffnung (11) auf der dem Bodenteil (10) gegenüberliegenden und der Antriebseinheit zugewandten Seite aufweist, wobei auf der der Antriebseinheit zugewandten Seite des Gehäuses (16) zur mechanischen Schnittstellen-Vorrichtung (4) hin eine Dichtvorrichtung (12) zum wasserdichten Abschließen der oben genannten Öffnung des Gehäuses (16) mit der mechanischen Schnittstellen-Vorrichtung (4) vorgesehen ist, und
- **dass** der zumindest eine Steckerschacht(18) an der von der Antriebsvorrichtung abgewandten Seite (7) des Gehäuses (16) am Bodenteil (10) angeordnet ist und durch einen gehäuseaußenseitig angeformten Steckerkragen (5) gebildet ist, der mit dem Bodenteil (10) und dem Gehäuse (16) einstückig und materialeinheitlich aus einem polymeren Werkstoff gebildet ist.

2. Vorrichtung nach Anspruch 1, **dadurch gekennzeichnet, dass** im Gehäuse eine Führungsvorrichtung (23) angeordnet ist in welche die Schaltungsplatine (8) durch die genannte Öffnung (11) des Gehäuses in Richtung des Bodenteils (10) einschiebbar ist, wobei im Bodenteil (10) im Bereich des zumindest einen Steckerschachts Durchstecköffnungen (21) vorgesehen sind, durch welche die Kontaktstifte (6), die mit einem Ende an der Schaltungsplatine befestigt sind und mit einem anderen Ende parallel zur Ebene der Schaltungsplatine in Einschubrichtung ausgerichtet sind, durchsteckbar sind.

3. Vorrichtung nach Anspruch 2, **dadurch gekennzeichnet, dass** die Durchstecköffnungen (21) in Einschubrichtung gesehen konisch zulaufend ausgebildet sind.

4. Vorrichtung nach Anspruch 3, **dadurch gekennzeichnet, dass** die Kontaktstifte (6) als 90 Grad abgewinkelte zylindrische Kontaktstifte oder prismatische Kontaktpfosten ausgebildet sind.

5. Vorrichtung nach Anspruch 4, **dadurch gekennzeichnet, dass** jede Durchstecköffnung (21) durch eine konische Bohrung mit einem lichten Durchmesser gebildet ist, der größer ist als ein Durchmesser der Kontaktstifte bzw. eine Querschnittsdiagonale der Kontaktpfosten.

6. Vorrichtung nach Anspruch 5, **dadurch gekennzeichnet, dass** die Kontaktstifte bzw. Kontaktpfosten aus Bronze hergestellt sind.

7. Vorrichtung nach Anspruch 6, **dadurch gekennzeichnet, dass** die Kontaktstifte bzw. Kontaktpfosten mit der Schaltungsplatine mittels einer Lötverbindung oder einer Einpressverbindung befestigt sind.

8. Vorrichtung nach Anspruch 7, **dadurch gekennzeichnet, dass** die Führungseinrichtung (23) durch Führungsleisten oder nutförmige Freistellungen gebildet ist, die an gegenüberliegenden Innenwandflächen der Schmalseiten des Gehäuses (16) ausgebildet sind.

9. Vorrichtung nach einem der Ansprüche 1 bis 8, **dadurch gekennzeichnet, dass** an der vom Antrieb abgewandten Seite (7) des Gehäuses (16) zumindest zwei Steckerkragen (5) ausgebildet sind.

## Claims

1. Control unit for controlling an electromotive drive unit,
- having a housing (16) which can be connected to the drive unit by means of a mechanical interface apparatus (4), and
- having a plug apparatus (17), which is formed on the housing, for plug-connecting a cable (20) which is routed to the housing from the outside, wherein contact pins (6) of the plug apparatus are arranged in at least one plug shaft (18) of the plug apparatus (17) and are electrically connected to conductor tracks of a printed circuit board (8) which is arranged in the interior of the housing, **characterized**
- **in that** the housing (16) is designed in the form of a cuboidal can, and has a base part (10) on a side (7) which is averted from the drive unit, and also has an opening (11) on that side which is opposite the base part (10) and faces the drive unit, wherein a sealing apparatus (12) for closing off the abovementioned opening in the housing (16) in a water-tight manner by way of the mechanical interface apparatus (4) is provided on that side of the housing (16) which faces the drive unit in the direction of the mechanical interface apparatus (4), and
- **in that** the at least one plug shaft (18) is arranged on the base part (10) on that side (7) of the housing (16) which is averted from the drive apparatus, and is formed by a plug collar (5) which is integrally formed on the outside of the housing and is formed in one piece with the base part (10) and the housing (16) and from the same polymeric material.

2. Apparatus according to Claim 1, **characterized in that** a guide apparatus (23) is arranged in the housing, it being possible for the printed circuit board (8) to be inserted into the said guide apparatus through the said opening (11) in the housing in the direction of the base part (10), wherein passage openings (21) are provided in the base part (10) in the region of the at least one plug shaft, it being possible for the contact pins (6), which are fastened to the printed circuit board by way of one end and are oriented parallel to the plane of the printed circuit board in the insertion direction by way of another end, to be passed through said passage openings.

3. Apparatus according to Claim 2, **characterized in that** the passage openings (21) are designed so as to taper in a conical manner as seen in the insertion direction.

4. Apparatus according to Claim 3, **characterized in that** the contact pins (6) are designed as cylindrical contact pins, which are bent through 90°, or prismatic contact posts.

5. Apparatus according to Claim 4, **characterized in that** each passage opening (21) is formed by a conical bore with a clear diameter which is greater than a diameter of the contact pins or a cross-sectional diagonal of the contact posts.

6. Apparatus according to Claim 5, **characterized in that** the contact pins or contact posts are produced from bronze.

7. Apparatus according to Claim 6, **characterized in that** the contact pins or contact posts are fastened to the printed circuit board by means of a solder connection or a press-in connection.

8. Apparatus according to Claim 7, **characterized in that** the guide device (23) is formed by guide strips or slot-like clearances which are formed on opposite inner wall faces of the narrow sides of the housing (16).

9. Apparatus according to one of Claims 1 to 8, **characterized in that** at least two plug collars (5) are formed on that side (7) of the housing (16) which is averted from the drive.

## Revendications

1. Unité de commande destiné à commander un dispositif d'entraînement à moteur électrique, comprenant
- un boîtier (16), qui peut être relié au dispositif d'entraînement par l'intermédiaire d'un dispositif d'interface mécanique (4), et
- un dispositif de connexion (17) prévu sur le boîtier, pour la connexion d'un câble (20) guidé de l'extérieur vers le boîtier, des broches de contact (6) du dispositif de connexion étant disposées dans au moins un compartiment de connecteur (18) du dispositif de connexion (17) et étant reliées électriquement à des pistes conductrices d'une platine de circuit (8), qui se trouvent à l'intérieur du boîtier, **caractérisée en ce que**
- le boîtier (16) est conçu sous la forme d'un contenant qui présente une forme de parallélépipède et comprend une partie de fond (10) sur un côté (7) opposé au dispositif d'entraînement ainsi qu'une ouverture (11) sur le côté opposé à la partie de fond (10) et orienté vers le dispositif d'entraînement, un dispositif d'étanchéité (12) pour la fermeture étanche à l'eau de l'ouverture mentionnée ci-dessus du boîtier (16) avec le dispositif d'interface mécanique (4) est prévu sur le côté du boîtier (16), orienté vers le dispositif d'entraînement, en direction du dispositif d'interface mécanique (4) et,
- l'au moins un compartiment de connecteur (18) est disposé au niveau de la partie de fond (10), sur le côté (7) du boîtier (16), opposé au dispositif d'entraînement et est formé par un col de connecteur (5) formé à l'extérieur du boîtier, qui est formé d'une seule pièce avec la partie de fond (10) et le boîtier (16) et est constitué du même matériau polymère.

2. Dispositif selon la revendication 1, **caractérisé en ce que**, dans le boîtier se trouve un dispositif de guidage (23) dans lequel la platine de circuit (8) peut être insérée à travers ladite ouverture (11), du boîtier en direction de la partie de fond (10), des ouvertures d'enfichage (21) étant prévues dans la partie de fond (10) au niveau de l'au moins un compartiment de connecteur, à travers lesquelles les broches de contact (6), fixées au niveau d'une extrémité à la platine de circuit et orientées, avec une autre extrémité, parallèle au plan de la platine de circuit dans la direction d'insertion, peuvent être enfichées.

3. Dispositif selon la revendication 2, **caractérisé en ce que** les ouvertures d'enfichage (21) présentent une forme conique vues dans la direction d'insertion.

4. Dispositif selon la revendication 3, **caractérisé en ce que** les broches de contact (6) sont formées comme des broches de contact cylindriques coudées à 90° ou des montants de contact prismatiques.

5. Dispositif selon la revendication 4, **caractérisé en ce que** chaque ouverture d'enfichage (21) est constituée d'un alésage conique avec un diamètre interne supérieur à un diamètre des broches de contact ou une diagonale de section transversale des montants de contact.

6. Dispositif selon la revendication 5, **caractérisé en ce que** les broches de contact ou les montants de contact sont constitués de bronze.

7. Dispositif selon la revendication 6, **caractérisé en ce que** les broches de contact ou les montants de contact sont fixées à la platine de circuit au moyen d'une liaison par soudure ou d'une liaison à force.

8. Dispositif selon la revendication 7, **caractérisé en ce que** le dispositif de guidage (23) est constitué de barrettes de guidage ou de dégagements en forme de rainures, qui sont prévus sur des surfaces de parois internes opposées des côtés étroits du boîtier (16).

9. Dispositif selon l'une des revendications 1 à 8, **caractérisé en ce que**, sur le côté (7) du boîtier (16), opposé au dispositif d'entraînement, se trouvent au moins deux cols de connecteurs (5).
